# EUROPÄISCHE PATENTANMELDUNG

(11) **EP 0 790 759 A1**
(43) Veröffentlichungstag der Anmeldung: **20.08.1997**
(21) Anmeldenummer: 96117584.1
(22) Anmeldetag: 02.11.1996
(51) Int. Cl.: H05K 3/36, H05K 1/14

(54) **Vorrichtung, insbesondere zur Verwendung in einem elektronischen Steuergerät**

(30) Priorität: 17.02.1996 DE 19605966
(71) Anmelder: ROBERT BOSCH GMBH, 70442 Stuttgart (DE)
(72) Erfinder: Wiesa, Thomas, 71665 Vaihingen (DE); Karr, Dieter, 75233 Tiefenbronn (DE); Schimitzek, Ralph, 74182 Obersulm/Sulzbach (DE)

(57) **Zusammenfassung**

Die Erfindung betrifft eine Vorrichtung, insbesondere zur Verwendung in einem elektronischen Steuergerät, mit einem Baugruppenträger (2) und einer Modulbaueinheit (10), die auf einfache Weise durch eine großflächige Verlötung der unbestückten Unterseite der Modulbaueinheit (10) mit diesem Baugruppenträger (2) hergestellt wird. Eine solche Verlötung kann in einem Reflow-Lötverfahren durchgeführt werden und ist automatisierbar und zur Serienproduktion geeignet. Die elektrischen Verbindungen (20) der Modulbaueinheit (10) werden räumlich und elektrisch getrennt von der mechanischen Verbindung der Modulbaueinheit auf dem Baugruppenträger geführt. Die Modulbaueinheit (10) kann als ein auf den Baugruppenträger (2) ergänzend aufgebrachtes Bauelement mit einer neuen zusätzlichen Funktion angesehen werden, so daß eine flexible Anpassung an ein bestimmtes Anforderungsprofil ganz einfach möglich ist, indem mehrere sich in Layout und Funktionsweise unterscheidende Modulbaueinheiten auf dem Baugruppenträger flexibel kombiniert werden.

## Beschreibung

### Stand der Technik

Die Erfindung betrifft eine Vorrichtung nach der im Oberbegriff des Anspruchs 1 angegebenen Gattung und ein Herstellungsverfahren für diese Vorrichtung.

Eine solche bereits aus der DE-OS 42 08 594 bekannte Vorrichtung mit einem ersten Baugruppenträger, der zum Beispiel eine Leiterplatte sein kann, weist eine mit diesem ersten Baugruppenträger verlötete Modulbaueinheit auf, die aus einem zweiten Baugruppentäger und darauf aufgebrachten Bauelementen besteht. Die in der DE-OS 42 08 594 gezeigte Modulbaueinheit zeigt eine Folienleiterplatte als zweiten Baugruppenträger mit im Reflow-Lötverfahren aufgebrachten SMD-Bauelementen (Surface Mounted Device-Bauelementen), die durch auf der Folien-Leiterplatte vorgesehene Leiterbahnen miteinander verbunden sind. Die Modulbaueinheit dient der Reparatur von defekten Leiterplatten oder der Ergänzung des Leiterplatten-Layouts durch weitere auf der Modulbaueinheit untergebrachte elektronische Bauelemente. Zu diesem Zweck wird die Folien-Leiterplatte an die als Pins bezeichneten elektrischen Kontaktstellen des ersten Baugruppenträgers angelötet. Die Schuttelfestigkeit der Folien-Leiterplatte wird durch einen zwischen der Folien-Leiterplatte und der Leiterplatte aufgebrachten Kleber gewährleistet. Als nachteilig muß dabei angesehen werden, daß bei der Aufbringung der Folienleiterplatte auf die Leiterplatte die zusätzliche mechanische Befestigung durch den Kleber und die Verlötung mit den Pins in getrennten Schritten erfolgen muß. Eine gute Wärmeableitung der Modulbaueinheit ist über den Kleber und die Pins kaum möglich. Nachteilig ist auch, daß die mit den Kontaktpins der Bauelemente verlöteten Modulbaueinheiten nur auf der unbestückten Rückseite der Leiterplatte aufgebracht werden können und die Verlötung manuell durchgeführt werden muß.

### Vorteile der Erfindung

Die erfindungsgemäße Vorrichtung mit dem kennzeichnenden Merkmal des Anspruchs 1 ist inbesondere dadurch vorteilhaft, daß die mechanische Befestigung der Modulbaueinheit auf einfache Weise durch eine großflächige Verlötung der unbestückten Unterseite des die Grundplatte der Modulbaueinheit bildenden zweiten Baugruppenträgers mit dem ersten Baugruppenträger hergestellt wird. Eine solche Verlötung kann in einem Reflow-Lötverfahren durchgeführt werden und ist automatisierbar und zur Serienproduktion geeignet. Außerdem verbessert eine derartige Lotschicht den Wärmeübergang von der Modulbaueinheit auf den ersten Baugruppenträger ganz erheblich, so daß eine gleichzeitige Kühlung der Modulbaueinheit bewirkt wird. Vorteilhaft ist weiterhin, daß die elektrische Verbindung der Modulbaueinheit räumlich und elektrisch getrennt von der mechanischen Verbindung der Modulbaueinheit auf dem Baugruppenträger erfolgt, da hierdurch die elektrischen Anschlüsse der Modulbaueinheit keinen mechanischen Belastungen ausgesetzt sind. Insbesondere vorteilhaft ist, daß die Bauelemente und Leitungsverbindungen auf dem ersten und dem zweiten Baugruppenträger unterschiedlich dimensioniert sein können. So ist es zum Beispiel möglich eine Modulbaueinheit mit sehr feinen Strukturgrößen, also zum Beispiel mit sehr schmalen Leiterbahnbreiten und sehr kleinen Durchkontaktierungen, auf einem Baugruppenträger mit sehr viel grober dimensionierten Strukturgrößen vorzusehen. Da die Bestückung und Verdrahtung der Modulbaueinheit in einem separaten Verfahren vorgenommen wird, ist es nicht erforderlich bei der Herstellung der groben Strukturgrößen auf dem ersten Baugruppenträger mit der gleichen Präzision und Sorgfalt vorzugehen wie bei der Herstellung der wesentlich dichteren Strukturen auf der Modulbaueinheit. Dies erniedrigt die Herstellungskosten ganz erheblich. Außerdem wirkt sich die Verwendung von Modulbaueinheiten mit kleinen Strukturgrößen platzsparend aus.

Weitere vorteilhaft Ausgestaltungen der Erfindung ergeben sich aus den in den Unteransprüchen ausgeführten Merkmalen. Durch das kennzeichnende Merkmal des Anspruchs 2 wird erreicht, daß die Modulbaueinheit unabhängig vom Vorhandensein weiterer spezieller Bauelemente auf dem ersten Schaltungsträger flexibel auf verschiedenen Baugruppenträgern zur Bereitstellung einer bestimmten zusätzlichen Funktion aufgebracht werden kann. Die Modulbaueinheit kann dann einfach als ein auf den ersten Baugruppenträger ergänzend aufgebrachtes Bauelement mit einer neuen zusätzlichen Funktion angesehen werden. Eine flexible Anpassung eines elektronischen Steuergerätes an ein bestimmtes Anforderungsprofil ist somit ganz einfach möglich, indem mehrere sich in Layout und Funktionsweise unterscheidende Modulbaueinheiten auf dem Baugruppenträger des Steuergerätes flexibel kombiniert werden.

Durch die Verwendung von Multilayer-Substraten nach Anspruch 3 und 4 ist eine vorteilhafte Ausgestaltung des zweiten Baugruppenträgers dadurch möglich, daß die elektrische Verdrahtung der Bauelemente auf dem zweiten Baugruppenträger in mehreren Lagen vorgenommen werden kann.

Weiterhin vorteilhaft ist die Ausgestaltung der elektrischen Anschlußfläche der Modulbaueinheit nach Anspruch 5 und 6, die ein einfaches Herstellen der elektrischen Verbindungen zwischen der Modulbaueinheit und den Anschlüssen der Leitungsverbindungen auf dem ersten Baugruppenträger ermöglicht.

Die Ausgestaltung der Erfindung gemäß den Ansprüchen 7 und 8 ermöglicht eine verbesserte Wärmeeinkopplung beim Stempellöten. Durch die metallisierten Ausnehmungen der Anschlußfläche nach Anspruch 7 gelangt die Wärme leichter an die Lotschichten unterhalb der Anschlußfläche. Durch die Verbindung der oberen und unteren metallischen Lage der Anschlußfläche nach Anspruch 8 wird die Wärme beim Stempellöten von der Oberseite der Anschlußfläche über deren Außenkante auf die über dem Lot liegende Unterseite abgeleitet.

Geeignete Hestellungsverfahren der Vorrichtung sind in den Ansprüchen 10 und 11 beschrieben. Sind die Abstände der elektrischen Anschlüsse auf der Anschlußfläche groß genug, so daß die Anschlüsse im Reflow-Lötverfahren verlötet werden können, so ergibt sich der Vorteil, daß die Verlötung des zweiten Baugruppenträgers mit dem ersten Baugruppenträger und die Verlötung der elektrischen Anschlüsse der Modulbaueinheit in einem gemeinsamen Reflow-Lötprozeß durchgeführt werden kann. Liegen die Anschlüsse der Modulbaueinheit dichter zusammen, so werden sie nach dem Auflöten der Modulbaueinheit auf den ersten Baugruppenträger durch ein Stempellötverfahren mit den Anschlüssen des ersten Baugruppenträgers verlötet.

### Zeichnung

Ein Ausführungsbeispiel der Erfindung ist in der Zeichnung dargestellt und wird in der nachfolgenden Beschreibung näher erläutert. Es zeigt
Fig. 1 eine Teilansicht eines Querschnitts durch einen Baugruppenträger eines elektronischen Steuergerätes mit einer aufgelöteten Modulbaueinheit,
Fig. 2 und Fig.3 einen vergrößerten Ausschnitt aus Fig. 1 für ein erstes und zweites Ausführungsbeispiel,
Fig.4 ein Ausführungsbeispiel eines in einem elektronischen Steuergerät einsetzbaren Baugruppenträgers mit einer aufgelöteten Modulbaueinheit und weiteren diskreten elektronischen Bauelementen.

### Beschreibung des Ausführungsbeispiels

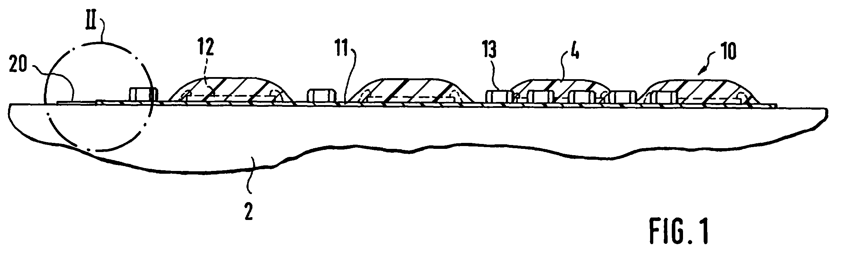

Die Fig. 1 zeigt einen Ausschnitt aus einem ersten Baugruppenträger 2 eines elektronischen Steuergerätes 1. Auf den ersten Baugruppenträger 2 ist eine Modulbaueinheit 10 aufgebracht, die aus einem zweiten Baugruppenträger 11 mit darauf aufgebrachten elektronischen Bauelementen 12 bzw. 13 besteht. Die Bauelemente 12 und 13 stellen beispielsweise die elektronische Steuerschaltung oder ähnliche Logikschaltkreise dar. In dem hier gezeigten Ausführungsbeispiel sind die gehäuselosen Bauelemente 12 in Chip on board-Technik auf den zweiten Baugruppenträger 11 aufgebracht und über Bonddrähte mit den nicht dargestellten Leitungsverbindungen verbunden. Die Bauelemente 11 sind zum Schutz mit einem kappenartigen Epoxid-Substrat, einem sogenannten "Globe Top" 4, bedeckt. Außer den Bauelementen 12 können sich noch weitere Bauelemente 13, wie zum Beispiel SMD-Bauelemente, auf dem Baugruppenträger 11 befinden. Die Bauelemente 12 und 13 sind über in der Fig. 1 nicht dargestellte Leitungsverbindungen miteinander verbunden und bilden unabhängig von eventuell weiteren auf dem ersten Baugruppenträger 2 vorhandenen Bauelementen eine elektronische Schaltung mit wenigstens einer der Modulbaueinheit 10 zuzuordhenden Funktion, welche durch den Einbau dieser Modulbaueinheit im Steuergerät 1 zur Verfügung steht. Im linken Bereich der Fig. 1 ist die Anschlußfläche 20 der Modulbaueinheit 10 angedeutet.

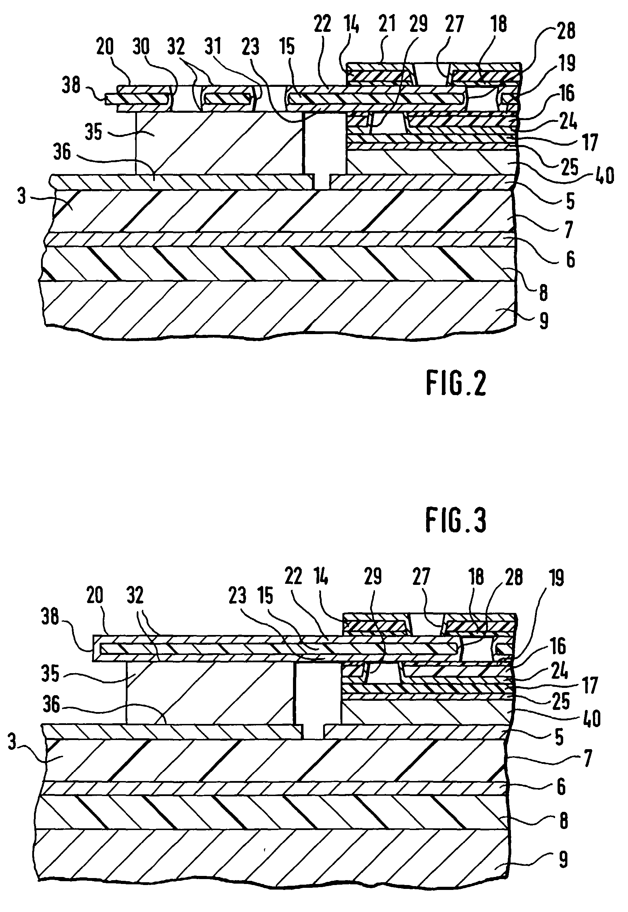

Dieser mit einem Kreis markierte Ausschnitt der Fig. 1 ist in einem ersten Ausführungsbeispiel in der Fig. 2 vergrößert und ohne die Bauelemente dargestellt. In dem gezeigten Beispiel besteht der Baugruppenträger 2 aus einer flexiblen Leiterplattenfolie 3 aus einer beidseitig mit Kupferlagen 5 und 6 beschichteten Polyimid-Schicht 7, die über eine elektrisch nicht leitfähige Prepreg-Schicht 8 mit einem Metallträger 9 aus zum Beispiel Aluminium fest verbunden ist. Es ist aber auch möglich ein anderes flexibles oder starres Dünnlaminat auf einem Metallträger zu verwenden. Der Baugruppenträger 11 der Modulbaueinheit 10, von dem hier nur ein Randbereich mit der Anschlußfläche 20 dargestellt ist, besteht aus einem Multilayer-Substrat mit vier Kupferlagen 21,22,23 und 24. Zwischen den Kupferlagen befinden sich weitere, die einzelnen Kupferlagen voneinander trennende Polyimid-Schichten 14,15 und 16. Die zusätzlich vorgesehenen haftvermittelnden Schichten 18 und 19 dienen der Haftung der Kupferlagen auf dem Polyimid. Unterhalb der Kupferlage 24 ist eine Prepreg-Schicht 17 aus einem elektrisch isolierenden und gut wärmeleifähigen Material aufgebracht, auf der wiederum eine großflächig ausgebildete einstückige Kupferebene 25 aufgebracht ist, welche die Unterseite des Baugruppentägers 11 bildet. Der Baugruppenträger 11 ist schließlich über eine unterhalb der Kupferebene 25 großflächig aufgebrachte Lotschicht 40 aus Blei/Zinn-Lot mit der Kupferlage 5 auf der Oberseite des Baugruppenträgers 2 verbunden.

Die Herstellung dieser Lötverbindung kann zum Beispiel dadurch erfolgen, daß die Lotschicht zunächst auf den Baugruppenträger 2 in einem Druckverfahren großflächig aufgebracht wird und danach der Baugruppenträger 11 auf die Lotschicht 40 aufgesetzt wird. Anschließend wird der Baugruppenträger 11 in einem Ofen im Reflow-Lötverfahren mit dem Baugruppenträger 2 verlötet.

Die Verdrahtung der auf der Modulbaueinheit befindlichen Bauelemente 12 und 13 erfolgt über Leiterbahnen auf den vier Kupferlagen 21,22,23 und 24 des Baugruppenträgers 11, dabei sind die Leitungsverbindungen auf den verschiedenen Kupferlagen über Durchkontaktierungen miteinander verbunden. In der in der Fig. 2 gezeigten Ausführung verbindet zum Beispiel eine Durchkontaktierung 27 eine Leiterbahn auf der Kupferlage 21 mit einer Leiterbahn auf der Kupferlage 22. Diese ist wiederum über eine Durchkontaktierung 28 mit einer Leiterbahn auf der dritten Kupferlage 23 und über eine dritte Durchkontakierung 29 mit einer Leiterbahn auf der vierten Kupferlage 24 verbunden. Die Leiterbahnen und Durchkontaktierungen der Modulbaueinheit 10 sind anders dimensioniert als die Strukturen des Baugruppenträgers 2. So sind die auf dem Baugruppenträger 11 der Modulbaueinheit befindlichen Leiterbahnen zum Beispiel 75 Mikrometer breit, der Durchmesser der Durchkontkatierungen beträgt dort ebenfalls 75 Mikrometer. Auf dem Baugruppenträger 2 sind dagegen die Leiterbahnen beispielsweise 300 Mikrometer breit, und der Durchmesser der Durchkontaktierungen beträgt 500 Mikrometer.

Die in der Fig. 2 gezeigte Anschlußfläche 20 der Modulbaueinheit 10 wird durch die beiden seitlich aus dem Baugruppenträger 11 herausgeführten Kupferlagen 22 und 23 mit der dazwischenliegenden Polyimidschicht 15 gebildet. Der die Anschlußfläche 20 bildende Teil der Kupferlagen 22 und 23 weist die einzelnen elektrischen Anschlüsse 32 der Modulbaueinheit 10 auf. Die Anschlüsse 32 werden durch auf den Kupferlagen 22 und 23 befindliche Leitungsverbindungen gebildet, die über Durchkontaktierungen 30 und 31 miteinander verbunden sind.

Unterhalb der Durchkontaktierungen 30 und 31 befinden sich Lötkontakte 35 aus Blei/Zinn-Lot. Jeder Lötkontakt 35 ist auf jeweils einen elektrischen Anschluß 36 einer auf der Kupferlage 5 des Baugruppenträgers 2 befindlichen Leiterbahn aufgebracht, so daß die Modulbaueinheit über die Lötkontakte 35 mit den weiteren auf dem ersten Baugruppenträger 2 befindlichen Schaltungsteilen elektrisch verbunden ist. Die Verlötung der Anschlüsse 32 mit den Anschlüssen 36 kann in einem Stempellötprozeß erfolgen. Hierbei wird zunächst Lot auf die Anschlüsse 36 aufgetragen und dann der Baugruppenträger 11 mit den Anschlüssen 32 auf das Lot aufgelegt. Anschließend wird ein Wärmestempel von oben auf die Anschlüsse 32 aufgedrückt. Über die wärmeleitenden Durchkontaktierungen 30 und 31 gelangt die Wärme auf die Unterseite der Anschlußfläche 20 und schmilzt das Lot auf. Das Stempellötverfahren bietet sich immer dann zur Verbindung der elektrischen Anschlüsse an, wenn die Anschlüsse 32 auf der Anschlußfläche 20 sehr eng beieinander liegen. Ist die Anschlußdichte nicht sehr groß und sind die Anschlüsse weiter voneinander entfernt, so kann die Verlötung der Anschlüsse auch in einem Reflow-Lötprozeß vorgenommen werden. Es ist dann insbesondere auch möglich, die Lötkontakte 35 zusammen mit den Lotschichten 40 in einem einzigen Reflow-Lötprozeß zu verlöten.

In der Fig. 3 ist ein weiteres Ausführungsbeispiel der Erfindung dargestellt, das sich nur geringfügig vom Ausführungsbeispiel der Fig. 2 unterscheidet. Die in der Fig. 3 gezeigte Anschlußfläche 20 weist im Bereich der Lötkontakte 35 keine Durchkontaktierungen 30,31 auf. Zur Ableitung der Wärme auf die über dem Lot liegende Unterseite der Anschlüsse 32 sind hier die Kupferlagen 22 und 23 an der Außenkante 38 der Anschlußfläche 20 miteinander verbunden.

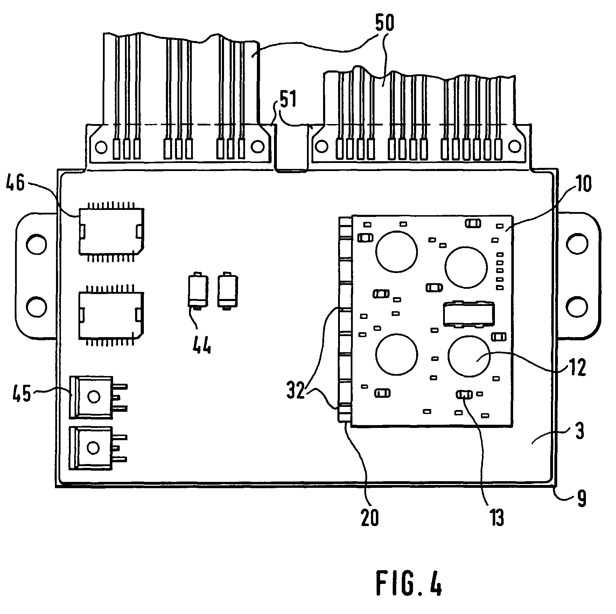

In Fig. 4 ist der Baugruppenträger 2 mit einer aufgelöteten Modulbaueinheit 10 und weiteren diskreten elektronischen Bauelementen 44,45 und 46 dargestellt. Auf den Metallträger 9 ist die Leiterplattenfolie 3 aufgeklebt. Der Metallträger 9 bildet zusammen mit der Leiterplattenfolie 3 den Baugruppenträger 2. Im oberen Bereich des Baugruppenträgers 2 sind flexible Leiterbahnen 50 angebracht, die eine Herausführung von Steckverbindern aus dem Steuergerät 1 ermöglichen. Die Leiterbahnen 50 sind durch einen Stempellötprozeß mit der Anschlußfläche 51 des Baugruppenträgers 2 verbunden. Auf dem Baugruppenträger 2 befindet sich eine Modulbaueinheit 10 mit den Bauelementen 12 und 13. Die Modulbaueinheit ist über auf der Anschlußfläche 20 befindliche Anschlüsse 32 mit den nicht dargestellten Anschlüssen 36 auf dem Baugruppenträger 2 verbunden. Außer der Modulbaueinheit 10 befinden sich noch weitere elektronische Bauelemente 44,45 und 46 auf dem Baugruppenträger 2, die auch SMD-Bauelemente sein können. Die Bauelemente 44,45 und 46 können entweder unabhängig von der Modulbaueinheit 10 oder zusammen mit dieser in einem einzigen Reflow-Lötverfahren auf den Baugruppenträger 2 aufgelötet werden.

## Patentansprüche

1. Vorrichtung, insbesondere zur Verwendung in einem elektronischen Steuergerät (1), mit einem ersten Baugruppenträger (2) und mit wenigstens einer aus einem zweiten Baugruppenträger (11) mit darauf aufgebrachten und über Leitungsverbindungen elektrisch miteinander verbundenen Bauelementen (12,13) bestehenden Modulbaueinheit (10), die über Lötverbindungen mit dem ersten Baugruppenträger verbunden ist, **dadurch gekennzeichnet**, daß der zweite Baugruppenträger (11) durch eine zwischen der unbestückten Unterseite (25) des zweiten Baugruppenträgers (11) und der Oberseite (5) des ersten Baugruppenträgers (2) großflächig aufgebrachte Lotschicht (40) mit dem ersten Baugruppenträger (2) verbunden ist.

2. Vorrichtung nach Anspruch 1, **dadurch gekennzeichnet**, daß die auf dem zweiten Baugruppenträger (11) vorgesehenen Bauelemente (12,13) und Leitungsverbindungen unabhängig von weiteren auf dem ersten Baugruppenträger (2) aufgebrachten Bauelementen (44,45,46) und/oder weiteren Modulbaueinheiten wenigstens eine elektronische Schaltung zur Erzeugung wenigstens einer Funktion der Modulbaueinheit (10) bilden.

3. Vorrichtung nach Anspruch 1 oder 2, **dadurch gekennzeichnet**, daß der zweite Baugruppenträger (11) aus einem Multilayer-Substrat besteht, bei dem die Leitungsverbindungen über mehrere Lagen (21,22,23,24) geführt sind.

4. Vorrichtung nach Anspruch 3, **dadurch gekennzeichnet**, daß der zweite Baugruppenträger (11) aus einer flexiblen, mehrere Kupferlagen (21,22,23,24) aufweisenden Leiterplattenfolie aus Polyimid besteht.

5. Vorrichtung nach einem der Ansprüche 1 bis 4, **dadurch gekennzeichnet**, daß einzelne elektrische Anschlüsse (32) der Modulbaueinheit (10) auf wenigstens einer seitlich an den zweiten Baugruppenträger (11) parallel anschließenden Anschlußfläche (20) vorgesehen sind und zur äußeren Verdrahtung über Lötkontakte (35) an der Unterseite der Anschlußfläche (20) mit auf dem ersten Baugruppenträger (2) vorgesehenen Anschlüssen (36) elektrisch leitend verbunden sind.

6. Vorrichtung nach Anspruch 5, **dadurch gekennzeichnet**, daß die wenigstens eine Anschlußfläche (20) an einer Seite des zweiten Baugruppenträgers (11) durch eine parallele Verlängerung und seitliche Herausführung zweier innerer Lagen (22,23) zusammen mit einer zwischen diesen Lagen vorgesehenen isolierenden Schicht (15) gebildet wird.

7. Vorrichtung nach Anspruch 6, **dadurch gekennzeichnet**, daß die wenigstens eine Anschlußfläche (20) Ausnehmungen (30,31) mit metallisierten Innenwandungen aufweist, die über den elektrischen Lötkontakten (35) angeordnet sind.

8. Vorrichtung nach Anspruch 6 oder 7, **dadurch gekennzeichnet**, daß die beiden die Oberseite (22) und die Unterseite (23) der Anschlußfläche (20) bildenden Lagen an der vom zweiten Baugruppenträger (11) abgewandten Außenkante (38) der Anschlußfläche (20) miteinander verbunden sind.

9. Vorrichtung nach einem der Ansprüche 1 bis 8, **dadurch gekennzeichnet**, daß außer der wenigstens einen Modulbaueinheit (10) weitere diskrete elektronische Bauelemente (44,45,46), insbesondere SMD-Bauelemente, auf dem ersten Baugruppenträger (2) vorgesehen sind.

10. Verfahren zur Herstellung einer Vorrichtung nach einem der Ansprüche 7 oder 8, **dadurch gekennzeichnet**, daß die unbestückte Seite (25) des zweiten Baugruppenträgers (11) in einem Reflow-Lötverfahren mit dem ersten Baugruppenträger (2) großflächig verlötet wird und daß die einzelnen elektrischen Anschlüsse (35) der Modulbaueinheit (10) auf der wenigstens einen seitlich an den zweiten Baugruppenträger (11) parallel anschließenden Anschlußfläche (20) im gleichen Reflow-Lötverfahren mit den Anschlüssen (36) des ersten Baugruppenträgers (2) verlötet werden.

11. Verfahren zur Herstellung einer Vorrichtung nach einem der Ansprüche 7 oder 8, **dadurch gekennzeichnet**, daß in einem ersten Verfahrensschritt die unbestückte Seite (25) des zweiten Baugruppenträgers (11) in einem Reflow-Lötverfahren mit dem ersten Baugruppenträger (2) großflächig verlötet wird und daß in einem zweiten Verfahrensschritt die einzelnen elektrischen Anschlüsse (35) der Modulbaueinheit (10) auf der wenigstens einen seitlich an den zweiten Baugruppenträger (11) parallel anschließenden Anschlußfläche (20) durch einen Stempellötprozeß mit den Anschlüssen (36) des ersten Baugruppenträgers (2) verlötet werden.

12. Verfahren zur Herstellung einer Vorrichtung nach Anspruch 10 oder 11, **dadurch gekennzeichnet**, daß auf dem ersten Baugruppenträger (2) vorhandene zusätzliche SMD-Bauelemente (44,45,46) während des Reflow-Lötverfahrens zur Verlötung der Modulbaueinheit (10) mit dem ersten Baugruppenträger (2) verlötet werden.
